# EUROPÄISCHE PATENTSCHRIFT

(11) **EP 0 379 898 B1**
(45) Veröffentlichungstag und Bekanntmachung des Hinweises auf die Patenterteilung: **20.07.1994**
(21) Anmeldenummer: 90100513.2
(22) Anmeldetag: 11.01.1990
(51) Int. Cl.: E06B 5/18, H05K 9/00

(54) **Geschirmte Tür mit Türrahmen für abgeschirmte Räume**
Screened door with door frame for screened rooms
Porte blindée avec chambranle de porte pour pièces blindées

(30) Priorität: 23.01.1989 DE 3901872; 06.03.1989 DE 3907181
(43) Veröffentlichungstag der Anmeldung: 01.08.1990
(73) Patentinhaber: Alfred Kunz GmbH & Co., D-80336 München (DE)
(72) Erfinder: Pallor, Hans Fritz, D-6800 Mannheim (DE)
(74) Vertreter: Gossel, Hans K., Dipl.-Ing.

(56) Entgegenhaltungen:
- EP-A- 0 095 743
- EP-A- 0 323 551
- DE-A- 3 101 519
- DE-A- 3 219 263
- DE-U- 8 619 214

## Beschreibung

Die Erfindung betrifft eine geschirmte Tür nach dem Oberbegriff des Anspruchs 1.

Für bestimmte Zwecke werden Räume benötigt, die gegenüber elektromagnetischen Wellen, elektrischen Pulsen und elektrischer Strahlung sicher abgeschirmt sind. Dabei soll die Abschirmung eine große Frequenzbreite mit hoher Dämpfung abdecken. Eine Abschirmung insbesondere gegenüber nieder- und hochfrequenten elektromagnetischen Wellen und elektrischen Pulsen ist beispielsweise notwendig, um Räume abhörsicher zu machen. Diese Abhörsicherheit bezieht sich nicht nur auf gesprochene Worte, sondern auch auf dem Informationsaustausch dienende Geräte. Beispielsweise besteht die Möglichkeit, die digitale Steuerung einer elektrischen Schreibmaschine abzuhören. In vielen Fällen ist es darüber hinaus erforderlich, empfindliche Geräte gegen eine diese kompromittierende Strahlung zu schützen, so daß deren unerwünschte Beinflussung ausgeschlossen ist. Die Notwendigkeit einer Abschirmung besteht nicht nur bei Räumen, in denen sensible Informatione ausgetauscht werden, sondern auch zum Schutz empfindlicher elektrischer und elektronischer Geräte.

Beispielsweise können Geräte zur Gehirnstrommessung und für kardiologische Untersuchungen und Behandlungen durch Störfrequenzen und Störpulse bis zur Funktionsunfähigkeit gestört und beeinträchtigt werden. Im militärischen Bereich und im zivilen Bereich, beispielsweise für Banken, Versicherungen und Kliniken, besteht daher ein Bedarf an geschirmten Räumen.

Während die Schirmung der Wände, Böden und Decken durch eine einwandfrei kontaktierte Schirmmetallauskleidung, beispielsweise durch Bleche der erforderlichen Permeabilität, problemlos vorgenommen kann, ist die Schirmung kontrollierter Durchdringungen, wie Türen und Fenster, schwierig. Besonders problematisch ist die schirmungsdichte Anordnung von Türen, da Spalte zwischen der Tür und dem Türrahmen und Einbauteile der Tür zu schirmungsundichten Leckstellen führen können. Insbesondere sind auch über die Türkonstruktion hinausragende Bauteile, beispielsweise äußere leitende Fahrrampenteile zu vermeiden, die im ungeschirmten Bereich angeordnet sind und eine gewisse Antennenwirkung zum geschirmten Teil haben können.

Bereits aus der EP-A-0 095 743 ist eine geschirmte Tür bekannt, bei der mittels entsprechender U-förmiger Profile und in diese eingreifende Stegelemente eine weitgehende Schirmung des Türelementes erreicht wird. Allerdings ergeben sich hier immer noch Probleme hinsichtlich von über die Tür hinausragenden Bauteilen.

Aufgabe der Erfindung ist es daher, gattungsgemäße geschirmte Türen für abgeschirmte Räume derart weiterzubilden, daß sie auch im Türschwellenbereich schirmungsdicht schließbar sind und daß gleichzeitig eine problemlose Befahrbarkeit sichergestellt ist.

Erfindungsgemäß wird diese Aufgabe ausgehend von der vorbekannten gattungsgemäßen abgeschirmten Tür durch die Merkmale des kennzeichnenden Teils des Anspruchs 1 gelöst. Demnach ist ein Steg in Form einer schwenkbaren Zunge gelenkig mit der den unteren Teil des Türrahmens bildenden Türschwelle verbunden und an seiner äußeren Schmalseite mit einer Abschrägung oder einer Abrundung in der Weise versehen, daß der untere Schenkel des an der unteren Seite der Tür befestigten U-förmigen Profils beim Schließen auf der durch die Abschrägung oder Abrundung der Zunge gebildeten Rand begleitet und diese in ihre Schließstellung zwischen den Kontakten anhebt. Nach dieser Ausgestaltung überbrückt die Zunge die Stufe zwischen der Schwelle und dem Boden, da sich die Zunge gleichsam rampenförmig auf dem Boden abstützt. Hierdurch ist es ermöglicht, über die Türschwelle mit einem Wagen oder einem mit Rollen versehenen Bett zu fahren. Zweckmäßigerweise ist nur die Schwelle mit der schwenkbaren Zunge versehen, während die Seitenräume des Türrahmens und das obere Querjoch in üblicher Weise U-förmige Profile aufweisen.

Neben einem U-förmigen Profil kommen auch andere geeignete metallische Profile in Betracht, die als haltende Aufnahmeprofile dienen können und in denen sich Kontaktfedern und/oder Kontakteinlagen geschützt anordnen lassen.

Die erfindungsgemäße geschirmte Tür ist im geschlossenen Zustand schirmungsdicht in den Türrahmen eingefügt, der seinerseits leitend und schirmungsdicht mit der Schirmung der Wandung verbunden ist. Die erfindungsgemäße geschirmte Tür schließt den abgeschirmten Raum schirmungsdicht ab, so daß das Grundprinzip des Faraday'schen Käfigs verwirklicht ist.

Der mit der erfindungsgemäßen abgeschirmten Tür versehende abgeschirmte Raum ist gegen Beeinflussung elektromagnetischer Wellen oder elektrischer Pulse von außen abgeschirmt. Weiterhin können auch keine elektromagnetischen Wellen oder Pulse von innen nach außen dringen.

Die erfindungsgemäß vorgesehenen Kontakt-Aufnahmeprofile können entweder an der Tür oder an dem Türrahmen oder aber auch teilweise an der Tür und an dem Türrahmen vorgesehen sein. Die inneren Flanken des Profils sind mit Kontakten bzw. Kontaktleisten versehen, die schirmungsgeeignete Kontaktierungen sicherstellen. Diese schirmungsgeeigneten Kontaktierungen können aus Materialien mit geeigneter Permeabilität bestehen, die federelastische Eigenschaften haben, und daher einen entsprechenden Kontaktdruck auf die in das Kontakt-Aufnahmeprofil eindringenden Leisten ausüben.

Die U-förmigen Profile können austauschbar an der Tür oder dem Türrahmen befestigt sein, so daß im Falle eines Verschleißes der Kontakte eine Auswechselung vorgenommen werden kann.

Die Zunge ist im Bereich des geschirmten Raumes innen angeordnet und dient dazu, die Kontaktfedern und die Kontaktfederaufnahmeprofile zu schützen und vor Verschmutzung zu bewahren und darüber hinaus die Befahrbarkeit bei geöffneter Tür sicherzustellen.

In der Offenstellung der Tür kann sich die Zunge auf dem Endbereich einer keilförmigen Auflauframpe abstützen, die zusätzlich vorgesehen werden kann, wenn die Schwelle eine größere Höhe aufweist.

Die Fahrrampe muß durch Einlage eines Isolierprofils zwischen dem inneren Türrampenbereich mit Zunge und dem äußeren Auffahrbereich, der zu dem ungeschirmten Bereich gehört, von diesem getrennt werden, da sonst eine durchgehende Antennenwirkung entstehen könnte. Diese unerwünschte Antennenwirkung wird dadurch verhindert, daß zwischen dem inneren und äußeren Teil der Fahrrampe eine Isolierschicht angeordnet wird. Weiterhin werden die inneren und äußeren Teile der Fahrrampe nicht leitend miteinander verbunden.

Die Zunge ist zweckmäßigerweise derart an der unteren Kante ihrer rückwärtigen Stirnseite an der Türschwelle oder einer mit dieser verbundenen Leiste angelenkt, daß die Stirnseite in der Schließstellung stumpf an einer Gegenfläche der Türschwelle oder Leiste anliegt. Durch dieses Anliegen kann die gut leitende Verbindung der Zunge mit der Schwelle zusätzlich verbessert werden.

Zweckmäßigerweise ist die Zunge durch ein im wesentlichen über ihre Länge verlaufendes Scharnier mit der Schwelle verbunden.

Der Steg besitzt in weiterer Ausgestaltung der Erfindung ein trapezförmiges Profil, das nur über einen Profilschenkel mit der Tür oder dem Türrahmen verbunden ist. Hierdurch weist der Steg ebenfalls federnde Schenkel auf, die die Kontaktierung mit den Kontaktleisten zusätzlich verbessern.

Die Kontakte können aus nebeneinander liegenden federnden Kontaktlamellen mit mittleren bogenförmig gekrümmten Teilen bestehen. Die Scheitel dieser bogenförmigen Teile weisen gegeneinander, wobei an die gekrümmten Teile in einer Ebene liegende gerade lappenförmige Teile anschließen können, von denen einer mit den Schenkeln verbunden ist, so daß der andere unter Druck gleitend ausweichen kann.

Die Kontakte können auch aus Schläuchen oder Rundprofilen aus elastomerem Material bestehen, deren Mäntel durch Drahtgeflechte, Drahtgewebe o.dgl. gebildet sind.

Bestehen die Kontakte aus Schläuchen mit leitenden Mänteln aus Drahtgeflechten o.dgl., können diese mit Druckluft aufblasbar sein, so daß sämtliche Paßungenauigkeiten beispielsweise zwischen dem Türblatt und dem Rahmen und/oder dem Halteaufnahmeprofil ausgeglichen werden können und eine überbrückende Kontaktierung gewährleistet ist.

Eine gute, schirmungsdichte Einpassung der Tür in den Türrahmen läßt sich insbesondere dann erreichen, wenn die Tür kurz vor ihrer Schließstellung sich in einer parallelen Ebene zu dem Türrahmen befindet, so daß die Stege senkrecht und somit verkantungsfrei in ihre Kontaktstellung zwischen den Schenkeln der U-förmigen Profile eingeschoben werden können. In weiterer Ausgestaltung der Erfindung ist daher vorgesehen, daß die Tür mit einem Pfosten des Türrahmens durch Scharnierbänder verbunden ist, die einen einerseits gelenkig mit dem Türrahmen und andererseits gelenkig mit der Tür verbundenen Lenker aufweisen. Durch diese Scharnierbänder mit zwei Gelenken läßt sich kurz vor der Schließstellung das Türblatt leicht winkelig zu dem Lenker ausrichten, so daß das Türblatt parallel zu sich selbst und zu dem Türrahmen in seine Schließstellung gedrückt werden kann, in der der Lenker wiederum eine parallele Lage zu der Ebene des Türblatts einnimmt.

Zweckmäßigerweise ist mit der Tür oder dem an der Tür befestigten Gelenkteil ein gegen das am Türrahmen befestigte Gelenkteil gerichteter Fortsatz verbunden, zwischen dem und einem Widerlager des Lenkers eine Druckfeder eingespannt ist, die bestrebt ist, den Lenker in seine zu dem Türblatt parallele Anschlagstellung zu verschwenken. Diese Ausgestaltung stellt sicher, daß die Tür über den wesentlichen Schwenkbereich um das äußere Gelenk des Scharnierbandes schwenkt.

Nach einer vorteilhaften Ausgestaltung ist vorgesehen, daß in einer Bohrung des türfesten Scharnierteils ein federbelasteter Bolzen angeordnet ist, der sich auf eine Widerlagerfläche des Lenkers abstützt und die Tür um einen Winkel zu schwenken trachtet, in dem sich die Tür unmittelbar vor ihrer Schließstellung in einer parallelen Ebene zu dem Türrahmen befindet. Dieser Bolzen gewährleistet somit ein Einknicken des Lenkers relativ zu der Ebene des Türblattes um einen Winkel, der den parallelen Einschub der Tür in die kontaktierte Klemmstellung sicherstellt.

Schließlich ist es erforderlich, die Tür in ihrer kontaktierten Klemmstellung mit dem Türrahmen zu verriegeln. Diese Verriegelung kann in weiterer Ausgestaltung der Erfindung darin bestehen, daß in den Längsseiten des Türblatts Gestänge längsverschieblich geführt sind, die obere und untere vorspringende Verriegelungszapfen oder Verriegelungsrollen tragen, die in entsprechende Schrägführungen des Türrahmens greifen. Diese Art der Verriegelung ist zweckmäßig, weil sie die von Hand in den Bereich der Schließstellung bewegte Tür parallel zu sich selbst in die Schließstellung zieht, in der die zungenartigen Stege zwischen die Kontakte der U-Profile greifen.

Zur Betätigung der die Verriegelungszapfen tragenden Gestänge können Kettentriebe vorgesehen sein. In weiterer Ausgestaltung der Erfindung ist vorgesehen, daß in der Tür eine durch einen Handhebel drehbare Welle gelagert ist, auf die das linke und rechte Gestänge antreibende Kettenräder aufgekeilt sind. Die Welle kann auch durch einen Elektromotor oder eine pneumatische Druckmittel-Kolben-Zylinder-Einheit verdrehbar sein.

Um zu verhindern, daß die Welle beispielsweise äußere und innere Schalen des Türblattes leitend miteinander verbindet und zwischen diesen einen Kurzschluß verursacht, kann die Welle mit einem mittleren nicht leitenden Teil, beispielsweise aus Kunststoff, versehen sein.

Die Kettentriebe stellen Einbauten dar, die die Schirmungsdichtigkeit beeinträchtigen können. Zweckmäßigerweise sind daher die Wellenteile beidseits der Kettenräder mit Scheiben aus schirmendem Material versehen.

Zweckmäßigerweise ist das Türblatt auf seiner Außenseite und seiner Innenseite mit schirmenden Platten versehen, die gegeneinander isoliert sind. Um die Dämpfungswirkung zu verbessern, können die Platten unterschiedliche Permeabilitäten aufweisen.

Zweckmäßigerweise besteht die Türblattabdeckung aus zwei unabhängig voneinander geformten Metallmodulen, beispielsweise einmal aus einer Abdeckung aus Kupferblech und zum anderen aus einer Abdeckung aus verzinktem Blech, so daß Schirmeigenschaften mit unterschiedlichen Permeabilitäten und dadurch günstige Doppelschirmeffekte erreicht werden.

Entsprechende Plattierungen und/oder Beschichtungen können auch zur nachträglichen Instandsetzung und Konfektionierung von vorhandenen herkömmlichen Türen vorgenommen werden. Die Plattierungen können beispielsweise aus Schirmfolien bestehen.

Schließlich können die Platten, vorzugsweise auf ihren nicht sichtbaren Innenseiten, mit pyramiden- oder Kegelförmigen Dämpfungskörpern aus schirmendem Material versehen sein. Diese Dämpfungskörper dienen als Reflektionsschutz in der Weise, daß sie elektromagnetische Wellen, elektrische Strahlung oder Störimpulse dadurch absorbieren, daß diese gegeneinander in der Weise reflektiert werden, daß sich diese totlaufen.

Insgesamt schafft die Erfindung eine geschirmte Tür, die einerseits als kontrollierte Durchdringung den ungestörten

Zugang zu dem abgeschirmten Raum gestattet und die andererseits in ihrer Schließstellung einen fugenlosen Kontakt mit dem schirmenden Material der Wände sicherstellt.

Ein Ausführungsbeispiel der Erfindung wird nachstehend anhand der Zeichnung näher beschrieben. In dieser zeigt
- Fig.1: eine Draufsicht auf den oberen Teil des Türrahmens,
- Fig.2: eine Draufsicht auf den unteren Teil des Türrahmens,
- Fig.3: einen Schnitt durch den Türrahmenteil nach Fig. 1,
- Fig.4: einen Schnitt durch den Türrahmenteil nach Fig. 2,
- Fig.5: einen Horizontalschnitt durch den Türrahmen,
- Fig.6: eine Draufsicht auf den oberen Teil der Tür,
- Fig.7: eine Draufsicht auf den unteren Teil der Tür,
- Fig.8: einen Querschnitt durch den oberen Türteil nach Fig. 6,
- Fig.9: einen Querschnitt durch den unteren Türteil nach Fig. 7,
- Fig.10: einen Horizontalschnitt durch die Tür,
- Fig.11: einen Querschnitt durch die Türschwelle und den unteren Randbereich der Tür im geschlossenen Zustand mit an die Türschwelle angelenkte Kontaktzunge,
- Fig.12: einen der Fig. 11 entsprechenden Schnitt im geöffneten Zustand der Tür,
- Fig.13: einen Schnitt durch die geschlossene Tür mit Türrahmen im Bereich eines Scharnierbandes,
- Fig.13a bis Fig.13d der Fig. 13: entsprechende Darstellungen der Tür im geöffneten und geschlossenen Zustand und in Zwischenstellungen,
- Fig.14: eine Draufsicht auf die Tür mit abgehobener Deckschale in schematischer Darstellung,
- Fig.14a: eine Draufsicht auf die Schrägführung für die Verriegelungszapfen in dem Türrahmen,
- Fig. 15: einen Schnitt durch die Tür längs der Linie a-a in Fig. 14
- Fig. 16: einen Schnitt durch die Tür im Bereich der Antriebskettenräder,

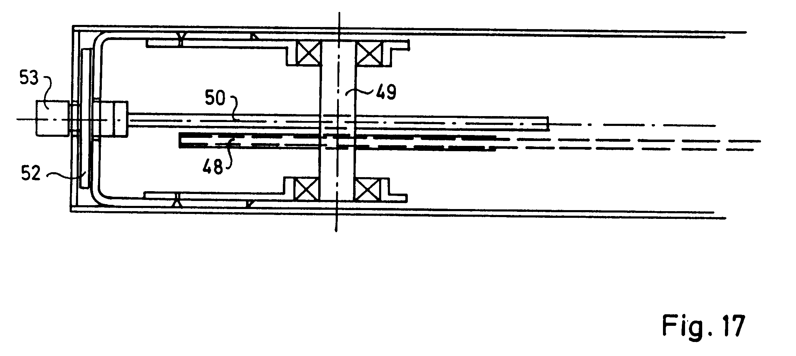

- Fig.17: einen Schnitt durch den Randbereich der Tür mit dem Verriegelungsgestänge und

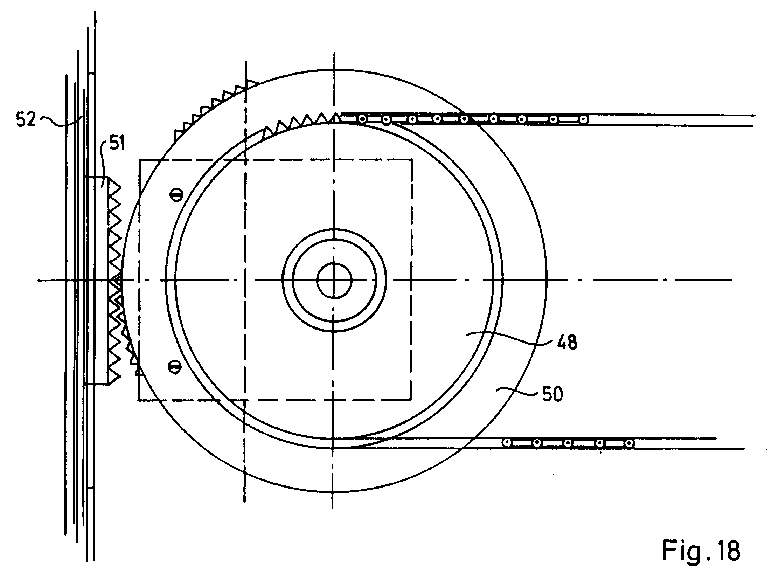

- Fig.18: einen Vertikalschnitt durch dne Randbereich der Tür gemäß Fig. 17.

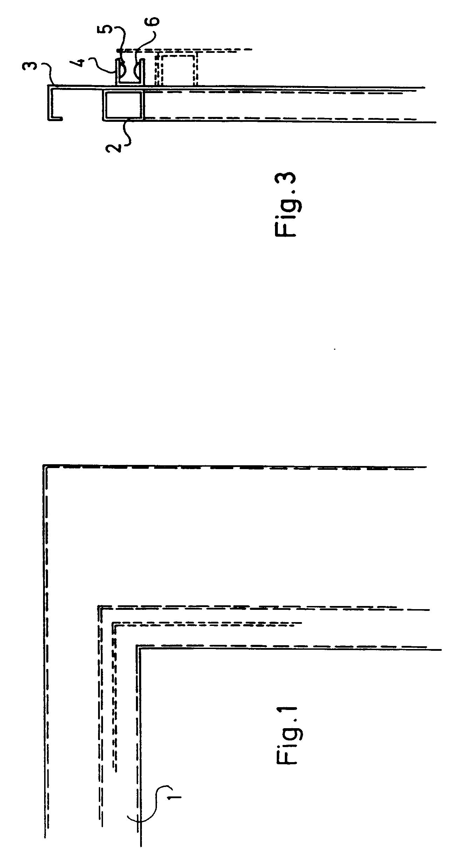

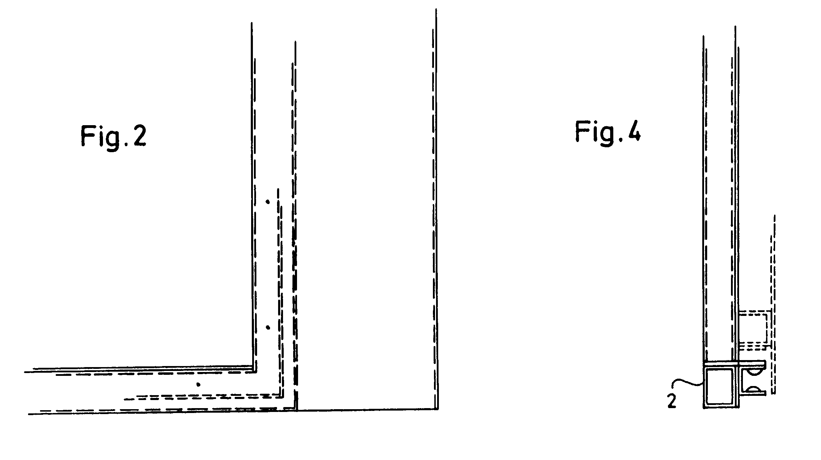

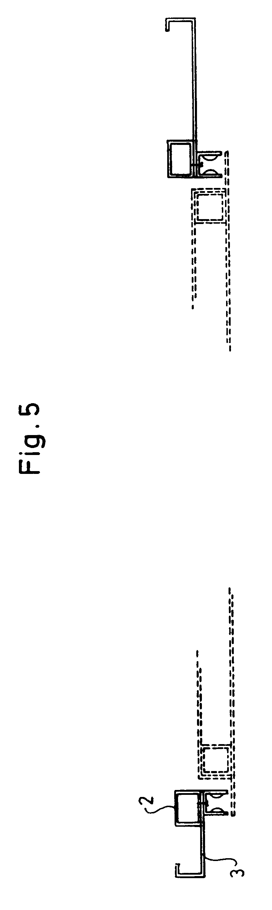

Wie aus den Fig. 1 bis 5 ersichtlich ist, besteht der Türrahmen 1 aus einem rechteckigen Rahmen aus miteinander verschweißten Kastenprofilen 2. Diese Kastenprofile 2 sind auf einer Seite mit schurzartigen Blechen 3 verschweißt, die in der Wand verankert und mit der Schirmung des Raumes leitend verbunden sind. Mit den den Türrahmen bildenden Kastenprofilen 2 sind auf einer Seite U-förmige Profile 4 verbunden, die auf den inneren Flanken ihrer Schenkel Kontakte 5,6 tragen. Die umlaufenden U-förmigen Profile sind so mit dem Türrahmen 1 verbunden, daß die Schenkel der Profile in der dargestellten Weise senkrecht auf der Ebene des Türrahmens stehen.

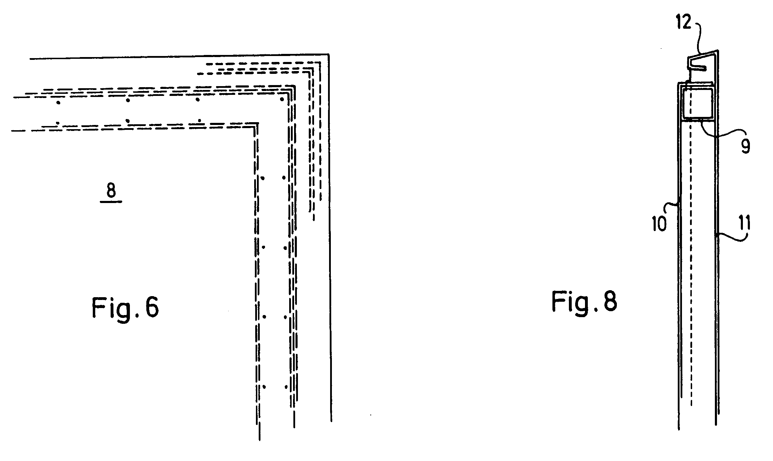

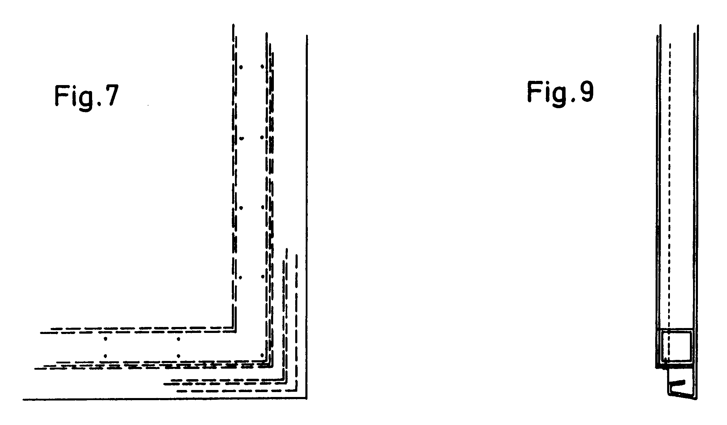

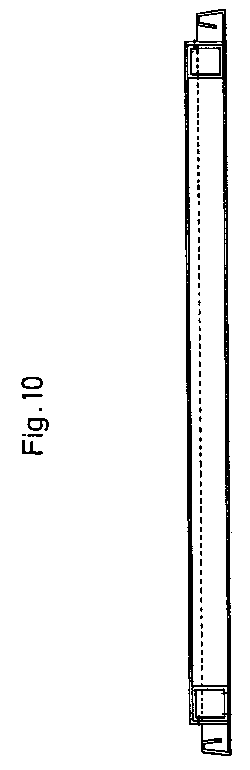

Wie aus den Fig.6 bis 10 ersichtlich ist, besteht die Tür 8 aus einem rechteckigen Rahmen aus miteinander verschweißten Kastenprofilen 9. Mit den Kastenprofilen sind innere und äußere Schalen 10,11 aus schirmendem Material unterschiedlicher Permeabilität verbunden. Diese Schalen können durch ein Dielektrikum von einander getrennt sein, so daß sie gegeneinander isoliert und miteinander nicht in leitender Verbindung stehen

Mit einer Seite des Profils bzw. einer Schale ist ein umlaufender Steg 12 verbunden, der ein etwa trapezförmiges Profil aufweist.

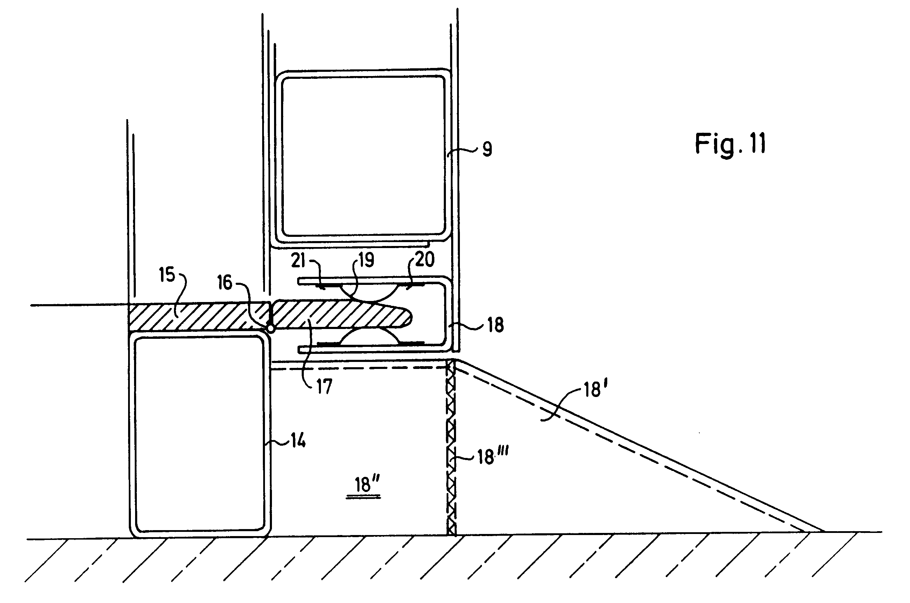

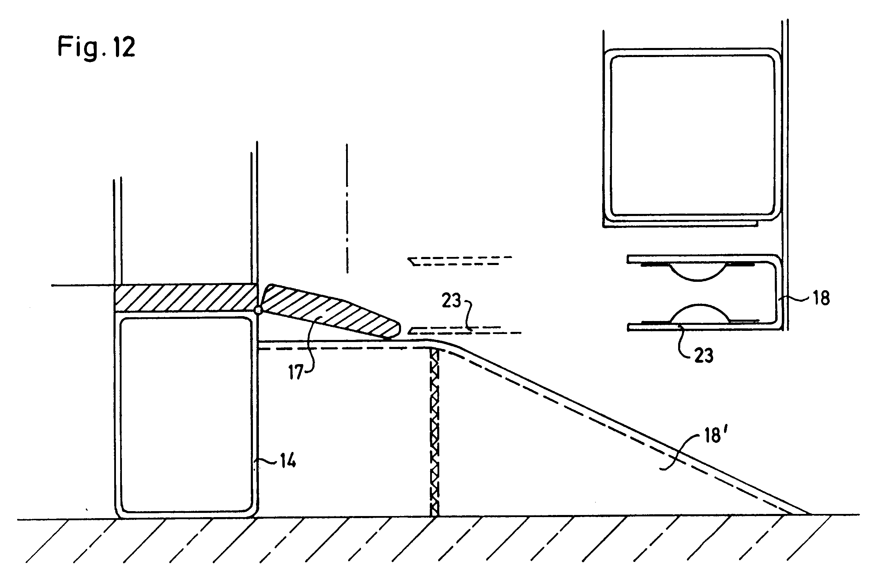

Aus den Fig. 11 und 12 ist eine besondere Ausgestaltung der Türschwelle ersichtlich. Mit der Oberseite der durch den unteren Rahmenholm des Türrahmens gebildeten Türschwelle 14 ist eine Flachleiste 15 aus schirmendem Material verbunden, beispielsweise verschweißt, an deren unteren äußeren Kanten um das Gelenk 16 schwenkbar eine Zunge 17 aus schirmendem Material angelenkt ist. Das Gelenk 16 besteht aus einem Scharnier mit abwechselnd ineinander greifenden eingerollten Ösen, durch deren fluchtende Bohrung die Scharnierachse hindurchgeführt ist. Bei dem Ausführungsbeispiel nach den Fig. 11 und 12 ist die Unterseite der Tür mit einem U-förmigen Profil 18 verbunden, das in Richtung auf die Ebene des Türrahmens offen ist. An den inneren Flanken der Schenkel sind die Kontakte 5,6 in Form von dicht nebeneinander liegenden Kontaktfedern angeordnet. Die Kontaktfedern weisen bogenförmig gekrümmte Mittelteile 19 und an diese anschließende Lappen 20,21 auf, die in einer Ebene liegen. Die Lappen 20 sind mit den inneren Flanken der Schenkel verbunden, so daß die Lappen 21 auf den Flanken gleiten können, wenn die Kontaktfeder durch die klemmend zwischen diese greifende Zunge 14 niedergedrückt werden.

Der keilförmige Teil 18′ der Rampe ist von dem Teil 18˝ mit waagerechter Oberfläche durch eine nicht leitende isolierende Trennschicht 18‴ getrennt. Weiterhin ist die Verbindung zwischen dem keilförmigen Rampenteil 18′ und dem etwa quaderförmigen Teil 18˝ so bewirkt, daß zwischen beiden Teilen keine leitende Verbindung vorhanden ist. Durch die Anordnung des Isolierprofils 18‴ zwischen dem inneren Türrampenbereich 18‴ der Fahrrampe, auf dem sich die Zunge 17 abstützen kann, und dem äußeren Auffahrbereich 18′ wird eine durchgehende Antennenwirkung, die eine gute Schirmung verhindern könnte, vermieden.

Wie aus Fig.12 ersichtlich ist, stützt sich im geöffneten Zustand der Tür die Zunge 17 auf einer keilförmigen Rampe 18′ ab, die die Höhe der Schwelle 14 ausgleicht. Wird die Tür geschlossen, greift der untere Schenkel 23 des Profils 18 an der abgerundeten äußeren Kante der Zunge 17 an, so daß diese dadurch angehoben wird und in ihre aus Fig.11 ersichtliche klemmende Schließstellung geführt wird. Die Ausgestaltung nach den Fig. 11 und 12 gestattet es, die Türschwelle 14 mit Wagen oder mit Rollen versehenen Betten zu überfahren.

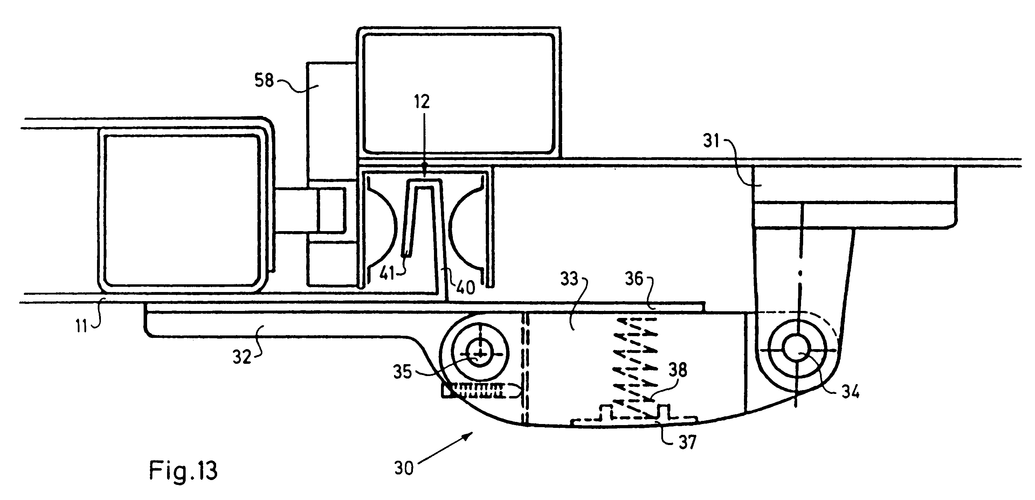

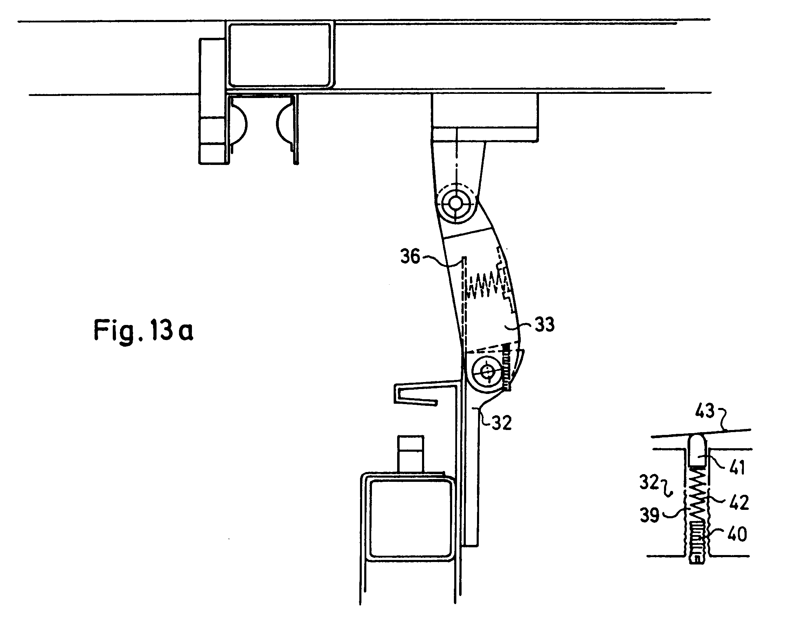

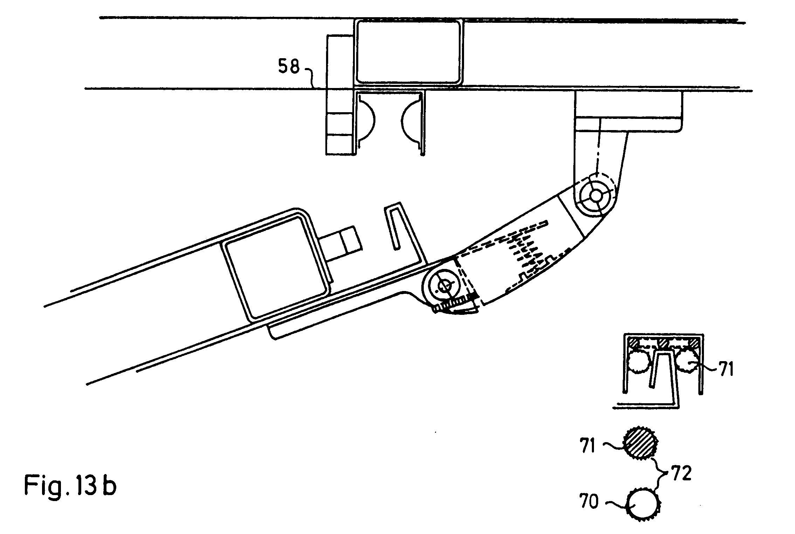

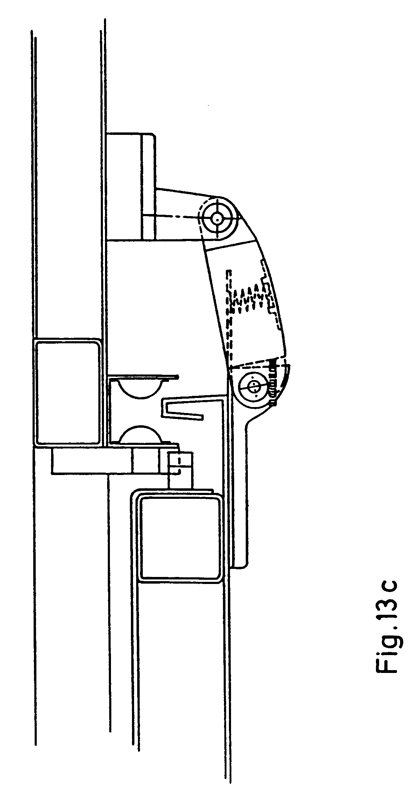

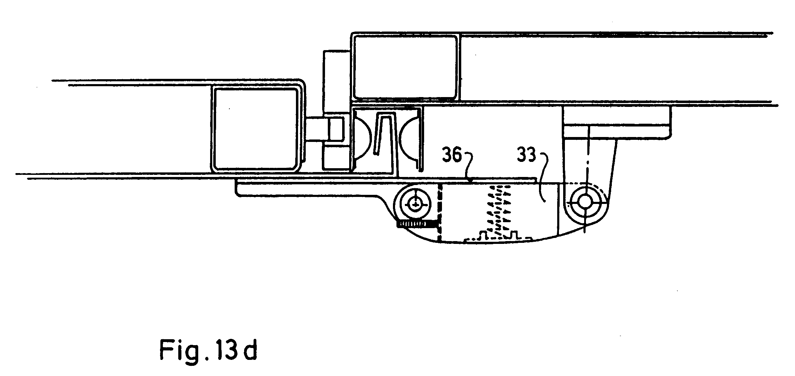

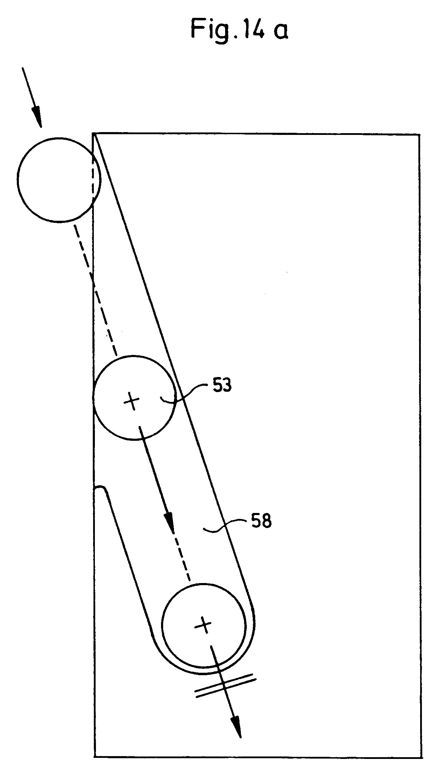

Aus den Fig. 13 bis 13d ist die Anlenkung der Tür an den Türrahmen ersichtlich. Die Anlenkung erfolgt durch ein Scharnierband 30, das aus einem fest mit dem Türrahmen verbundenen festen Lagerteil 31, einem fest mit der Tür verbundenen beweglichen Lagerteil 32 und einem Lenker 33 besteht, der um die Gelenkbolzen 34,35 schwenkbar gelenkig mit dem festen Scharnierteil 31 und dem beweglichen Scharnierteil 32 verbunden ist.

Überkragend ist mit dem Türblatt eine Steg 36 verbunden, der sich bis über den mittleren Teil des Lenkers 33 erstreckt. Zwischen diesem überkragenden Stegteil 36 und einem mit dem Lenker 33 verbundenen Widerlager 37 ist eine Druckfeder 38 mit Vorspannung eingespannt. Diese Druckfeder ist bestrebt, den Lenker 33 in seiner zu dem Steg 37 parallelen Lage zu halten.

Wie aus Fig. 13a ersichtlich ist, ist das bewegliche Scharnierteil 32 mit einer Bohrung 39 versehen, in der zwischen einer Madenschraube 40 und einem Bolzen 41 eine Druckfeder 42 eingespannt ist. Der Bolzen 41 stützt sich auf einer Widerlagerfläche 43 des Lenkers 33 in der Weise ab, daß die Kraft der Druckfeder 38 überwunden und der Lenker 33 zu der aus einer Stahlplatte bestehenden Stegplatte 36 eine um den Winkel α abgewinkelte Stellung einnimmt. Dabei entspricht der Winkel α, wie aus Fig.13c ersichtlich ist, der Abwinkelung, die erforderlich ist, daß das Türblatt unmittelbar vor der Schließstellung eine zu der Ebene des Türrahmens parallele Stellung einnimmt. Wird nun die Tür in die aus den Fig. 13 und 13d ersichtliche Schließstellung gedrückt, wird die Kraft der Druckfeder 42 überwunden und der Lenker 33 nimmt eine zu der Stegplatte 36 parallele Stellung ein.

Wie aus den Fig. 13 bis 13d ersichtlich ist, weist der Steg 12 grundsätzlich die Form eines Trapez auf. Dabei ist ein Trapez-Schenkel 40 mit einer Platte 11 des Türblatts verbunden, während der andere Schenkel 41 frei endet, so daß der Steg 12 insgesamt um den Schenkel 40 und die Schenkel 40,41 relativ zueinander federn können.

Aus Darstellungsgründen ist in den Fig. 13 bis 13d ein Abstand zwischen dem Steg 12 und den Kontaktfedern gezeigt, obwohl diese selbstverständlich in der Schließstellung kraftschlüssig aneinanderliegen.

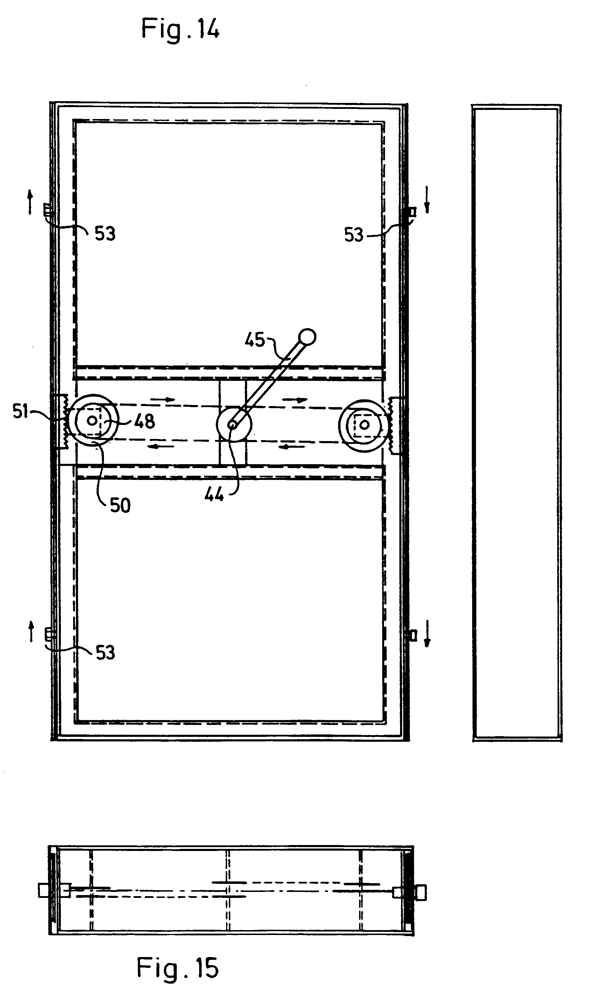

Zwischen den inneren und äußeren Türblättern ist, wie aus den Fig. 14 bis 16 ersichtlich ist, eine Welle 44 gelagert, die über einen Handhebel 45 verdrehbar ist. Auf der Welle 44 sind Kettenräder 46,47 aufgekeilt, über die Laschenketten laufen, die über Kettenräder 48 in den Seitenbereichen der Tür gelagerte Wellen 49 antreiben, auf die Zahnräder 50 aufgekeilt sind, die mit Zahnleisten 51 kämmen, die in der dargestellten Weise Stangen oder Leisten 52 in ihren Führungen verschieben, die die Türseiten überragende Verriegelungszapfen 53 tragen. Jede Leiste 52 trägt zwei Verriegelungszapfen 53, wobei Verriegelungszapfen gegenüberliegender Seiten in unterschiedliche Richtungen verschieblich sind, wie aus Fig. 14 ersichtlich ist.

Die Verriegelungszapfen greifen in bekannter Weise in Schrägführungen des Türrahmens, wie aus Fig.14a ersichtlich ist. Die Einbaulage dieser Schrägführungen ist insbesondere auch aus den Fig. 13 bis 13d ersichtlich.

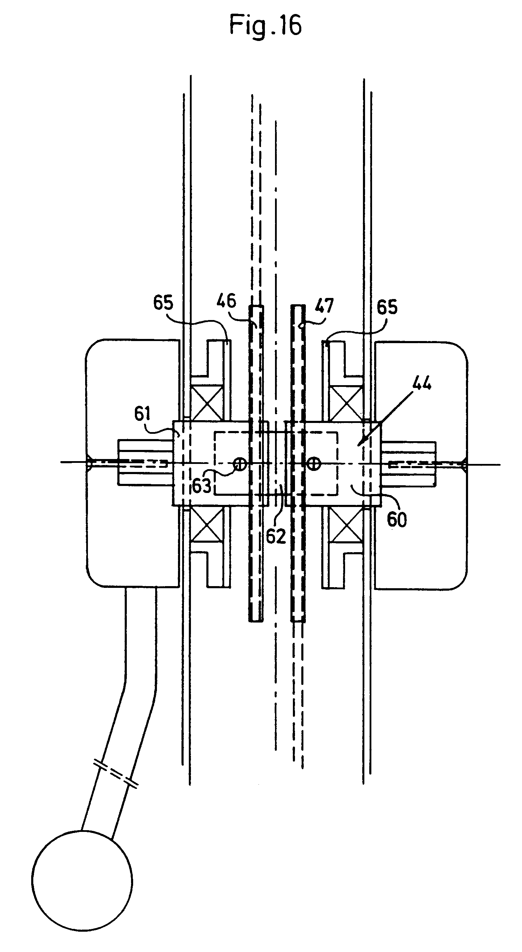

Die Welle 44 besteht, wie in Fig. 16 dargestellt ist, aus zwei metallischen Endteilen 60,61 , die auf ihren inneren einander gegenüberliegenden Stirnseiten mit Sacklochbohrungen versehen sind, in die ein Wellenstück 62 aus Kunststoff eingesetzt ist, das durch Klemmschrauben 63 in den Sacklochbohrungen gehalten ist.

Auf die Wellenteile 60,61 aus Stahl sind beidseits der Kettenräder 46,47 scheibenförmige Platten 65 aus schirmendem Material aufgesetzt. Auch diese Scheiben können, wie die Schalplatten der Tür, aus Schirmungsmaterial unterschiedlicher Permeabilität bestehen, um dadurch die Dämpfungswirkung zu verbessern.

Die Kontakte können, wie aus Fig. 13 b ersichtlich ist, auch aus Hohlschläuchen 70 oder Rundprofilen 71 aus elastomerem Material bestehen, die mit einer Metallgeflechtumwicklung 72 versehen sind.

## Patentansprüche

1. Geschirmte Tür für abgeschirmte Räume, mit einem Türrahmen (1) und einem Türflügel (8), deren Türflügel (8) mit einer schirmenden Beschichtung oder Plattierung (10, 11) versehen und deren Türflügel (8) in Schließstellung über die Randbereiche aller Seiten elektrisch leitend mit dem Türrahmen (1) verbunden ist,
wobei der Türflügel oder der Türrahmen in ihren Randbereichen umlaufend einerseits mit einem U-förmigen Profil (18, 23) und andererseits mit einem Steg (12, 17) jeweils aus schirmenden Material versehen sind,
wobei die Schenkel des U-förmigen Profils (18, 23) und der Steg (12, 17) derart gegeneinander gerichtet sind, daß sich beim Schließen des Türflügels (8) der Steg (12. 17) in eine Eingriffsstellung zwischen den Schenkeln des U-förmigen Profils (18, 23) einführen läßt,
und wobei die inneren Flanken der Schenkel des U-förmigen Profils (18, 23) mit federnden Kontakten (19) aus schirmendem Material versehen sind, die in der Schließstellung kraftschlüssig klemmend an beiden Seiten des Stegs (12, 17) anliegen,
**dadurch gekennzeichnet**,
daß der Steg in Form einer schwenkbaren Zunge (17) gelenkig mit der den unteren Teil des Türrahmens bildenden Türschwelle (14) verbunden und an seiner äußeren Schmalseite mit einer Abschrägung oder einer Abrundung in der Weise versehen ist, daß der untere Schenkel (23) des an der unteren Seite des Türflügels befestigten U-förmigen Profils (23) beim Schließen der durch die Abschrägung oder Abrundung der Zunge (17) gebildeten Rampe gleitet und diese in ihre klemmende Schließstellung zwischen den Kontakten (5, 6) anhebt.

2. Tür nach Anspruch 1, dadurch gekennzeichnet, daß die Zunge (17) derart an der unteren Kante ihrer rückwärtigen Stirnseite an der Türschwelle (14) oder einer mit dieser verbundenen Leiste (15) angelenkt ist und daß die Stirnseite in der Schließstellung stumpf an einer Gegenflanke der Türschwelle (14) oder Leiste (15) anliegt.

3. Tür nach Anspruch 1 oder 2, dadurch gekennzeichnet, daß die Zunge (17) oder ein im wesentlichen über ihre Länge laufendes Scharnier (c, b) mit der Türschwelle (14) verbunden ist.

4. Tür nach einem der vorhergehenden Ansprüche, dadurch gekennzeichnet, daß sich in der Offenstellung der Tür die Zunge (17) auf dem Endbereich einer keilförmigen Auffahrrampe (18') abstützt.

5. Tür nach einem der vorhergehenden Ansprüche, dadurch gekennzeichnet, daß die Zunge (17) ein trapezförmiges Profil aufweist und nur über einen Profilschenkel mit dem Türrahmen verbunden ist.

6. Tür nach einem der vorhergehenden Ansprüche, dadurch gekennzeichnet, daß die Kontakte (5, 6) aus nebeneinander liegenden federnden Kontaktlamellen mit mittleren bogenförmig gekrümmten Teilen (19) bestehen.

7. Tür nach einem der vorhergehenden Ansprüche, dadurch gekennzeichnet, daß die Kontakte aus Schläuchen oder Rundprofilen mit Mänteln aus Drahtgeflecht o.dgl. bestehen.

8. Tür nach einem der vorhergehenden Ansprüche, dadurch gekennzeichnet, daß die Tür mit einem Pfosten des Türrahmens durch Scharnierbänder (30) verbunden ist, die einen einerseits gelenkig mit dem Türrahmen und andererseits gelenkig mit der Tür verbundenen Lenker aufweisen.

9. Tür nach Anspruch 8, dadurch gekennzeichnet, daß mit der Tür oder dem an der Tür befestigten Gelenkteil ein gegen das am Türrahmen befestigte Gelenkteil gerichteter Fortsatz verbunden ist, zwischen dem und einem Widerlager des Lenkers eine Druckfeder (38) eingespannt ist, die bestrebt ist, den Lenker in seine zu dem Türblatt parallele Anschlagstellung zu verschwenken.

10. Tür nach Anspruch 8 oder 9, dadurch gekennzeichnet, daß in einer Bohrung des mit der Tür verbundenen beweglichen Scharnierteils ein federbelasteter Bolzen (41) angeordnet ist, der sich auf eine Widerlagerfläche des Lenkers abstützt und die die Tür um einen Winkel zu dem Lenker zu schwenken trachtet, in dem sich die Tür unmittelbar vor ihrer Schließstellung in einer parallelen Ebene zu dem Türrahmen befindet.

11. Tür nach einem der vorhergehenden Ansprüche, dadurch gekennzeichnet, daß in den Längsseiten des Türblatts Gestänge oder Leisten verschieblich geführt sind, die obere und untere vorspringende Verriegelungszapfen (53) oder Verriegelungsrollen tragen, die in Schrägführungen des Türrahmens greifen.

12. Tür nach Anspruch 11, dadurch gekennzeichnet, daß die die Verriegelungszapfen tragenden Gestänge durch Kettentriebe verschieblich sind.

13. Tür nach einem der vorhergehenden Ansprüche, dadurch gekennzeichnet, daß in der Tür eine durch einen Handhebel drehbare Welle gelagert ist, auf die zwei das linke und rechte Gestänge antreibende Kettenräder (46, 47) aufgeteilt sind.

14. Tür nach einem der vorhergehenden Ansprüche, dadurch gekennzeichnet, daß die die Kettenräder tragende Welle durch einen Elektromotor oder eine pneumatische Kolben-Zylinder-Einheit verdrehbar ist.

15. Tür nach einem der Ansprüche 11 bis 14, dadurch gekennzeichnet, daß die Welle mit einem mittleren nicht leitenden Teil versehen ist.

16. Tür nach einem der Ansprüche 11 bis 15, dadurch gekennzeichnet, daß die leitenden Wellenteile beidseits der Kettenräder mit Scheiben (65) aus schirmendem Material versehen sind.

17. Tür nach einem der vorhergehenden Ansprüche, dadurch gekennzeichnet, daß das Türblatt auf seiner Außen- und Innenseite mit schirmenden Platten versehen ist, die vorzugsweise gegeneinander isoliert sind.

18. Tür nach Anspruch 17, dadurch gekennzeichnet, daß die Platten unterschiedliche Permeabilitäten aufweisen.

19. Tür nach einem der vorhergehenden Ansprüche, dadurch gekennzeichnet, daß die schirmenden Platten der Tür mit pyramidenförmigen oder kegelförmigen Dämpfungskörpern versehen sind.

## Claims

1. A screened door for screened rooms comprising a door frame (1) and a door leaf (8), said leaf (8) being provided with a screening coating or plating layer (10 and 11) and said door leaf (8), in the closed position thereof, being connected at edge parts of all sides in a electrically conducting manner with the door frame (1),
said door leaf or said door frame being provided in the marginal system thereof in a surrounding manner on the one hand with a U-like section (18 and 23) and on the other hand with a rib (12 and 17), each of same being of a screening material,
the limbs of the U-like section (18 and 23) and the rib (12 and 17) being so directed towards one another that on closing the door leaf (8) the rib (12 and 17) may be fitted into an engagement position between the limbs of the U-like section (18 and 23),
and the inner flanks of the limbs of the U-like section (18 and 23) being provided with resilient electrical contact means (19) of screening material, which are in gripping, frictional engagement with the two sides of the rib (12 and 17),
characterized in that
the rib in the form of a pivotal flap (17) is connected with the door sill (14) constituting the lower part of the door frame and at its outer narrow side has an oblique or rounded form in such a manner that, during closing, the lower limb (23) of the U-like section (23) secured to the lower side of the door leaf slides in relation to a ramp constituted by such oblique or rounded form of the flap (17) and lifts the ramp into the gripping closed position thereof between the electrical contact means (5 and 6).

2. The door as claimed in claim 1, characterized in that the flap (17) is so pivoted at the lower edge of its rear end side on the door sill (14) or on a rail (15) connected with the same and that in the closed setting the end side bluntly abuts a mating flank of the door sill (14) or the rail (15).

3. The door as claimed in claim 1 or in claim 2, characterized in that the flap (17) or a hinge (c and b) extending along the length thereof is connected with the door sill (14).

4. The door as claimed in any one of the preceding claims, characterized in that in the open setting of the door the flap (17) bears against the end part of a wedge-like ramp (18').

5. The door as claimed in any one of the preceding claims, characterized in that the flap (17) possesses a trapezoidal profile and is only connected with the door frame by means of one limb of the profile.

6. The door as claimed in any one of the preceding claims, characterized in that the electrical contact means (5 and 6) consist of adjacently arranged resilient contact blades with central arcuately curved parts (19).

7. The door as claimed in any one of the preceding claims, characterized in that the electrical contact means consist of flexible pipes or round sections with casings of braided wire or the like.

8. The door as claimed in any one of the preceding claims, characterized in that the door is connected with a post of the door frame by means of an elongated butt hinge (30) which on the one hand is articulatingly connected with the door frame and on the one hand has links articulatingly connected with the door.

9. The door as claimed in claim 8, characterized in that a heel, which is directed towards the joint part attached to the door frame, is connected with the door or with the joint part attached to the door, and a compression spring (38) is arranged between the heel and an abutment on the link and urges the link to pivot into an abutment position in parallelism to the door leaf.

10. The door as claimed in claim 8 or claim 9, characterized in that a spring-loaded pin (41) is arranged in a hole in the movable hinge part connected with the door and bears against an abutment surface on the link and urges the door to pivot through an angle in relation to the link, in which the door is just short of its closed position in a plane parallel to the door frame.

11. The door as claimed in any one of the preceding claims, characterized in that rods or rails are slidingly mounted in the longitudinal side of the door leaf and bear upper and lower projecting locking pins (53) or locking rollers, which fit into the oblique guides of the door frame.

12. The door as claimed in claim 11, characterized in that the rods bearing the locking pins are adapted to be moved by sprocket chain drives.

13. The door as claimed in any one of the preceding claims, characterized in that a shaft able to be turned by a handle is bearinged in the door and has two sprocket wheels (46 and 47) keyed on it driving the left and right rods.

14. The door as claimed in any one of the preceding claims, characterized in that the shaft bearing the sprocket wheels is able to be turned by an electric motor or by a pneumatic piston and cylinder unit.

15. The door as claimed in any one of the claims 11 addition 14, characterized in that the shaft is provided with a central non-conductive part.

16. The door as claimed in any one of the claims 11 through 15, characterized in that the conductive shaft parts on either side of the sprocket wheels are provided with disks (65) of screening material.

17. The door as claimed in any one of the preceding claims, characterized in that the door leaf is provided on its outer and inner sides with screening plates, which are preferably insulated from one another.

18. The door as claimed in claim 17, characterized in that the plates have different permeabilities.

19. The door as claimed in any one of the preceding claims, characterized in that the screening plates of the door are provided with pyramidal or conical damping bodies.

## Revendications

1. Porte blindée pour des pièces blindées, comprenant un encadrement de porte (1) et un battant de porte (8), dont le battant de porte (8) est pourvu d'un revêtement de blindage ou d'un placage (10, 11) et dont le battant (8) est relié dans la position de fermeture de façon électriquement conductrice par les zones de bord de tous les côtés à l'encadrement de porte (1),
le battant de porte ou l'encadrement de porte étant pourvu dans leurs zones de bord tout autour d'une part d'un profil en forme de U (18, 23) et d'autre part d'une barre (12, 17) respectivement en un matériau de blindage,
les branches du profil en forme de U (18, 23) et la barre (12, 17) étant orientées les unes relativement aux autres de façon que lorsqu'on ferme le battant de porte (8), la barre (12, 17) peut être mise en prise entre les branches du profil en forme de U (18, 23),
et les flancs internes des branches du profil en forme de U (18, 23) étant pourvus de contacts élastiques (19) en un matériau de blindage qui, dans la position de fermeture, s'applique, par une liaison de serrage par force, aux deux côtés de la barre (12, 17),
caractérisée
en ce que la barre sous la forme d'une languette pivotante (17) est reliée de façon articulée au seuil de porte (14) formant la partie inférieure de l'encadrement de porte et qu'elle est pourvue à son côté étroit extérieur d'un chanfrein ou d'un arrondi de telle façon que la branche inférieure (23) du profil en forme de U (23) fixé au côté inférieur du battant de porte glisse lors de la fermeture sur la rampe constituée par le chanfrein ou l'arrondi de la languette (17) et soulève celle-ci dans sa position de fermeture bloquée entre les contacts (5, 6).

2. Porte selon la revendication 1, caractérisée en ce que la languette (17) est articulée à l'arête inférieure de son côté frontal arrière au seuil de la porte (14) ou à une traverse (15) connectée à celui-ci, et en ce que le côté frontal s'applique dans la position de fermeture bout-à-bout à un contre-flanc du seuil de porte (14) ou de la traverse (15).

3. Porte selon la revendication 1 ou 2, caractérisée en ce que la languette (17) ou une charnière (c, b) s'étendant sensiblement sur la longueur de celle-ci est reliée au seuil de porte (14).

4. Porte selon l'une des revendications précédentes, caractérisée en ce que, lorsque la porte est dans la position ouverte, la languette (17) prend appui sur la zone d'extrémité d'une rampe d'accès en forme de coin (18').

5. Porte selon l'une des revendications précédentes, caractérisée en ce que la languette (17) a un profil en forme de trapèze et est reliée seulement par une branche profilée à l'encadrement de porte.

6. Porte selon l'une des revendications précédentes, caractérisée en ce que les contacts (5, 6) sont constitués de lamelles de contact élastiques situées les unes à côté des autres présentant des parties médianes (19) courbées suivant une forme d'arc.

7. Porte selon l'une des revendications précédentes, caractérisée en ce que les contacts sont constitués de tuyaux ou de profils ronds pourvus d'enveloppes en treillis en fil métallique ou analogue.

8. Porte selon l'une des revendications précédentes, caractérisée en ce que la porte est reliée à un poteau de l'encadrement de porte par des bandes de charnière (30) qui présentent une bielle articulée, d'une part, à l'encadrement de porte et, d'autre part, articulée à la porte.

9. Porte selon la revendication 8, caractérisée en ce qu'un appendice orienté contre la partie articulée fixée à l'encadrement de porte est relié à la porte ou à la partie articulée fixée à la porte, et entre lequel et une butée de la bielle est placé un ressort de pression (38) qui s'efforce de faire pivoter la bielle dans sa position de butée parallèle au vantail de porte.

10. Porte selon la revendication 8 ou 9, caractérisée en ce qu'un boulon soumis à l'action d'un ressort (41) est disposé dans un perçage de la partie de charnière mobile reliée à la porte, et qui prend appui sur une surface de butée de la bielle et qui s'efforce de faire pivoter la porte suivant un certain angle relativement à la bielle, dans lequel la porte se trouve directement devant sa position de fermeture dans un plan parallèle à l'encadrement de porte.

11. Porte selon l'une des revendications précédentes, caractérisée en ce que des tringleries ou des barres sont guidées de façon déplaçable dans les côtés longitudinaux du vantail de porte qui portent les tenons de verrouillage (53) ou des rouleaux de verrouillage supérieurs et inférieurs en saillie qui s'engagent dans des guidages en biais de l'encadrement de porte.

12. Porte selon la revendication 11, caractérisée en ce que les tringles supportant les tenons de verrouillage sont déplaçables par des commandes à chaîne.

13. Porte selon l'une des revendications précédentes, caractérisée en ce qu'un arbre pouvant être tourné par une manivelle est logé dans la porte sur lequel sont répartis deux roues à chaîne (46, 47) entraînant les tringles gauche et droite.

14. Porte selon l'une des revendications précédentes, caractérisée en ce que l'arbre supportant les roues à chaîne peut être entraîné par un moteur électrique ou une unité pneumatique à piston et à cylindre.

15. Porte selon l'une des revendications 11 à 14, caractérisée en ce que l'arbre est pourvu d'une partie médiane qui n'est pas conductrice.

16. Porte selon l'une des revendications 11 à 15, caractérisée en ce que les parties d'arbre conductrices sont pourvues des deux côtés des roues à chaîne de disques (65) en un matériau de blindage.

17. Porte selon l'une des revendications précédentes, caractérisée en ce que le vantail de porte est pourvu sur ses côtés extérieur et intérieur de plaques de blindage qui sont isolées de préférence les unes par rapport aux autres.

18. Porte selon la revendication 17, caractérisée en ce que les plaques ont des perméabilités différentes.

19. Porte selon l'une des revendications précédentes, caractérisée en ce que les plaques de blindage de la porte sont pourvues de corps d'amortissement en forme de pyramide ou de cône.
